# EUROPEAN PATENT SPECIFICATION

(11) **EP 2 514 713 B1**
(45) Date of publication and mention of the grant of the patent: **02.10.2013**
(21) Application number: 11003325.5
(22) Date of filing: 20.04.2011
(51) Int. Cl.: B81B 7/00

(54) **A micro-electromechanical system (MEMS) device**
Mikroelektromechanische Systemvorrichtung (MEMS-Vorrichtung)
Dispositif à système micro-électromécanique (MEMS)

(43) Date of publication of application: 24.10.2012
(73) Proprietor: Tronics Microsystems S.A., 38926 Crolles (FR)
(72) Inventor: Renard, Stephane, 38560 Champ sur Drac (FR); Filipe, Antoine, 38700 La Tronche (FR); Collet, Joel, 38410 Saint Mrtin d'Uriage (FR); Boillot, Francois-Xavier, 38000 Grenoble (FR)
(74) Representative: Roshardt, Werner Alfred

(56) References cited:
- WO-A1-2010/112676
- US-A1- 2005 161 753
- US-A1- 2008 029 863
- US-A1- 2009 091 018

## Description

### Technical Field

The invention relates to a micro-electronic device, preferably a micro-electromechanical system (MEMS) device (e.g. a sensor for measuring acceleration or rotation speed or an actuator) comprising at least two substrates, at least one micro-electronic structure, preferably a movable structure in a MEMS-layer, wherein said micro-electronic structure is arranged in a cavity which is encapsulated between the at least two substrates. The invention also relates to a method for manufacturing such a device.

### Background, prior art

There is a wide range of MEMS devices for detecting accelerations e.g. US 5,220,835 (Ford), US 5,488,864 (Ford), US 5,900,550 (Ford), US 6,000,287 (Ford), US 6,082,197 (Zexel), US 6,308,568 (Murata). There are also sensor devices that are sensitive to accelerations in different directions.

US 5,065,628 (Fraunhofer Gesellschaft) discloses a MEMS (Micro-ElectroMechanical System) device for measuring accelerations in several different directions. The accelerations are measured by three micromechanical sensors, each consisting of an inert mass (proof mass) that is sensitive to a motion in only one of the different directions e.g. x, y and z. The sensors are integrated in a single crystal surface layer.

'Typically, a MEMS device comprises at least one movable structure such as a mobile mass or a mobile cantilever encapsulated in a cavity.

US 5,623,099 (Temic Telefunken) shows a basic structure for packaging a capacitive acceleration sensor. Two semiconductor substrates are bonded together at their major surfaces by a thermally grown oxide. A cavity is formed between the two substrates for encapsulating a mobile mass sensing acceleration in one direction. Each substrate provides a part of the box-shaped cavity and the mobile element, which defines a variable capacity within the cavity, moves perpendicularly to the substrate. The thermally grown oxide provides an electrical insulation between the substrate plates.

US 5,381,300 (Sextant Avionique) and US 6,153,917 (Akebone Brake) propose an acceleration sensor that is made of three silicon plates welded together by an annealing process. Instead of using a single silicon oxide layer for bonding the substrates a sandwich consisting of first insulating layer, a conducting layer and a second insulating layer is applied. The sandwich structure avoids stray capacities influencing the measurements.

WO 2010/112676 (Valtion) proposes a casing for a micro- or nano-sized electromechanical sensor used for measuring oscillations such as acoustic emission. The casing might also be used for sensors that are tuned to lower frequencies for monitoring the kinetic state of an object. In order to provide low-cost manufacture of the sensor casing the same type of technology which is known from casings of integrated circuits is used. A sensor chip is attached to the casing so as to constitute a sealed structure together with the casing material. The casing is made of several layers of low temperature co-fired ceramic (LTCC). The separate layers are aligned vertically and sintered together at a relatively low temperature of usually below 1000°C. The layers may contain circuit elements, metallic conductive areas, and other functional parts such as passive circuit elements like resistors, capacitors, and inductances.

US 2008/029863 (Honeywell) describes a low cost wafer-level vacuum package for a MEMS device. A first and a second wafer are bonded to the MEMS layer. The MEMS device is enclosed in a vacuum cavity and is surrounded by a frame in the same layer to serve as a seal ring. Silicon pins are embedded in the glass wafers and penetrate the wafer for contacting metal pads in the vacuum cavity. They also contact the separate MEMS-layer frame surrounding the MEMS device. A plurality of MEMS cavities are formed and once the cap wafer is bonded to the base wafer, then the entire wafer is diced in order to separate the cavities into definite units (individual die) for eventual attachment to a circuit board.

US 2005/161753 (National research initiative) is directed to MEMS RF devices fabricated on a LTCC substrate, The MEMS components are e.g. elertronically-tunable variable capacitors, closed-loop controlled variable capacitors, tunable inductors, tunable LC filters or tunable LC networks. The MEMS RF device is fabricated on a stack of multiple layers of an LTCC material which serve as a substrate. A second stack of LTCC layers forms the cap of a cavity for the MEMS device and the two stacks are bonded together. The method may be used to fabricate a Phased Array Antenna.

US 2009/091 018 (Kyocera Corp.) proposes "four electronic component sealing substrates" In order to suppress the influences of electromagnetic coupling and radio frequency noises in MEMS devices.

For multiple axes sensor devices, one of the key points is cross-axis sensitivity. The cross-axis sensitivity determines how much acceleration for an accelerometer (or rotation speed for a gyrometer), perpendicular to the measuring axis, couples to the output. Typically, cross-axis sensitivity should be not more than 1% and preferably substantially less than 1% on best performing devices, and less than 5% for low-performing devices.

### Summary of the invention

It is an object of the invention to provide a micro-electronic device, preferably a microelectromechanical system (MEMS) device which is insensitive to electro-magnetic interferences. Preferably, the device should be adapted for integrating two or more movables structures or two or more micro-electric circuits (or combinations thereof) in a single chip. The chip may comprise a sensor and/or an actuator and/or an electronic circuit. It is a further object to reach electrical decoupling of separate devices (preferably of different sensors or actuators or electronic circuits) arranged in close proximity by a minimum consumption of substrate area. It is a further object of the invention to provide a process for manufacturing such a device.

According to the invention, the above mentioned objectives are achieved by a microelectronic device, preferably a MEMS device comprising:
a) at least two substrates, each being a single body, preferably mainly consisting of a semiconductor material,;
b) a micro-electronic structure, preferably at least one movable structure in a MEMS-layer;
c) wherein said micro-electronic structure, preferably said movable structure is arranged in a cavity which is encapsulated between the at least two substrates;
d) an electrically conducting frame surrounding said micro-electronic structure, preferably said movable structure, and arranged at an interface of the two substrates ,
e) wherein the frame is electrically separated from said micro-electronic structure, preferably form said movable structure; and
f) electrically connected by at least a first and a second electrically conducting connection to said frame and said first and second substrates, respectively.

The method for manufacturing such a device comprises the steps of:
a) providing at least two substrates forming a cavity for a movable structure, wherein each of the substrates is a single body, preferably mainly consisting of a semiconductor material,
b) providing at least one micro-electronic structure, preferably a movable structure in a MEMS-layer, said micro-electronic structure being provided in the cavity,
c) providing an electrically conducting frame at an interface of the two substrates and the frame surrounding the micro-electronic structure, preferably the movable structure,
d) bonding the two substrates and the conducting frame together for encapsulating the micro-electronic structure in the cavity, wherein the frame surrounds the micro-electronic structure and the frame is electrically separated from said micro-electronic structure inside said frame,
e) providing a first and a second electrically conducting connection between said frame and said first and second substrates, respectively.

In the framework of the present invention a "micro-electronic" device is meant to be a general term encompassing "micro-electromechanical systems (MEMS)" as well as "micro-electronic circuits".

According to the invention a substrate may be a single or multi-layer body that can be handled and processed as a self-containing element and that can be bonded face-to-face to the other substrate in the course of a bonding step. Each substrate of the invention may be a single unit or may consist of two substrates or may be a layered element such as an SOI (Silicon On Insulator) structure or.an element coated with thin layers. All these types of substrates are known in the prior art (see also introductory chapter "background, prior art" of this specification). Typically the substrates mainly consist of a semiconductor material such as crystalline silicon defining the bulk material of the substrate. The outer surface of the substrate (i.e. the surface that is not at the interface to the frame and not inside the cavity) should have a resistance less than 5 Ohm in order to enable the Faraday cage effect. With typical thickness of several 100 µm, preferably in the range of 300 - 450 µm, this is leading to a resistivity less than 50 mOhm x cm.

In the framework of the present invention, a movable structure comprises a mobile mass or a mobile cantilever supported by a flexible suspension element at a distance to the walls of the cavity. The movable structure may therefore oscillate or rotate about one or more geometric axis (x, y, z) or may be deflected from a still (inactive) position by electrostatic forces. The movement of the mobile element may be initiated by inertial forces or by electrical fields. According to the invention, the movable structure is implemented in a MEMS layer. The MEMS layer may be a separate substrate or may be formed on top of one of the two substrates.

The electrically conducting frame is at an interface between the two substrates. It defines a substantially closed ring or hedge around the movable structure in the MEMS-layer. In the top plan view, the ring or hedge may have a rectangular shape or any polygonal shape running around the movable structure.

The electrically conducting frame is part of a so-called Faraday cage formed by the two substrates and the frame. The Faraday cage does not have to be perfectly closed in order to perform the intended electromagnetic shielding effect. It is to be remembered that the electromagnetic shielding affect of a Faraday cage may also be achieved by a mesh-type structure, meaning that a local opening in the Faraday should not be a problem as long as its typical dimension is less than the wavelength of the electromagnetic field (i.e. less than 300µm for a frequency of 1 THz). Such openings may be necessary for electrically contacting the mobile structure or the electrodes inside the cavity from outside of the Faraday cage.

Generally speaking, the proposed structure has the effect of a Faraday cage keeping electrical stray fields and electromagnetic disturbances away from the movable structure inside the cavity and from the electrical measurements and/or from electrical control elements inside the cavity. Preferably, by using an electrically conducting wafer sealing (such as a metallic sealing) it is possible to use a seal width as low as 30 µm. Therefore, it is possible to ensure a perfect seal around each movable structure (which may comprise a proof mass or a cantilever switch) and to achieve (if desired) multi-movable structures with minimum cross-axis sensitivity by a minimum amount of substrate area.

Indeed, according to the prior art the standard seal between active wafer and cap wafer is performed with glass-frit technology, with a thickness of 5 µm and a width of around 200 µm (micron). Implementing a Faraday cage around each sensor has a huge impact on the die area and can decrease the cost of the MEMS devices (e.g. sensors or actuators) very substantially.

The invention results in devices that have higher performance and that can also be used in harsh environment (with a lot of electromagnetic perturbations), such as in automotive applications, without sacrificing die area, i.e. unit cost.

MEMS-layer:
Optionally, the frame is part of the same MEMS-layer as the movable structure inside the cavity. This has the advantage that the production of the frame does not need an additional step in the production process. The MEMS-layer is typically made of silicon, preferably of mono crystalline silicon.

Material and width of frame:
Optionally, the frame consists of crystalline silicon that is sufficiently high doped for achieving an adequate conductivity. The conductivity may be in the range of e.g. 10 - 20 mOhm x cm. The frame may have a width in a direction parallel to a main surface of the substrate of not more than 150 µm (micron). From the point of view of mechanical stability the width of the frame should be not less than 50 µm (micron). This provides sufficient mechanical stability during handling of the MEMS layer. An optimal range of the frame width for silicon structures is 50 - 150 µm (micron)
It is also possible to use a different material for the frame. For example, if the MEMS structure is not made from crystalline silicon, it may be advantageous not to use crystalline silicon for the frame but to use the same material as the MEMS structure. Of course, it is not mandatory to make the frame from the same material as the MEMS structure.

The width of the frame (i.e. of the beams of the frame) may be as small as possible to save die area. However, under certain conditions the width may also be above 50 or above 100 µm when the conductivity of the frame material is only moderate or if the metal sealing technology requires a larger area.

Thickness of frame:
Optionally, the frame has a thickness (measured in a direction normal to the surface of the substrate, i.e. z-direction) that is within a thickness range defined by the mobile mass of the sensor. This means that the frame may be produced from the same layer as the mobile mass of the MEMS structure. For instance, the frame may be etched into the silicon layer at the periphery of the MEMS structure.

However, it is also possible to use the invention in combination with any type of mobile mass, in particular with a mobile mass that is not on the same level as the frame,

Connection between frame and first substrate:
Optionally, there is a first electrically conducting connection at the interface plane between the frame and the first substrate. Said interface plane substantially corresponds to the plane of the main surface of the substrate. Metal stripes placed on the main surface of the first substrate may form the conducting connection and ensure the electrical contact between the first substrate and the frame. In the top plan view, the stripes are quasi buried under the frame. The stripes may define a closed rectangle or polygon line surrounding the MEMS structure of a sensor in the same way as the frame does.
Alternatively, the conducting connection between the first substrate and the frame may also be placed at the outside periphery of the frame. Further more, the conducting connection does not have to be formed as continuous metal stripes that are so to speak a foot-print of the shape of the frame. Electrical sealing may also be achieved by several separate contacting elements (contact pads).

Connection between frame and second substrate:
Optionally, the second electrically conducting connection is provided by a conducting layer applied at the outer periphery of the frame and at a peripheral face of the second substrate. The peripheral face is a surface that is orthogonal to or inclined to the main face i.e. the x-y-face of the substrate. This connection is therefore not interposed between the mating main surfaces of the second substrate and of the frame. Rather more, it is arranged at the periphery of the device (i.e. outside the area of the frame) for electrically connecting the frame and the substrates to ground voltage.

Alternatively, it is possible to use a similar connection as described between the frame and the first substrate.

Inclined peripheral face:
Optionally, the peripheral surface of the second substrate has a section that is inclined at an angle of < 90° with respect to the main surface of the substrate. The electrical connection is applied to the inclined section of the peripheral surface and to the peripheral face of the frame.

Nevertheless an alternative solution is to avoid usage of the above mentioned connection in order to save die surface. Of course in this case the Faraday cage surrounding the cavity containing the movable structure is not completely closed in terms of conductivity, but the gap of isolation is so small that the interferences are sufficiently small.

Insulating layer between frame and second substrate:
Optionally, the frame and the second substrate are connected (or bonded) at their mating main surfaces by an insulating bonding material, preferably by an oxide. This insulating layer may also be used to electrically isolate the MEMS structure (mobile mass, cantilever etc.) from the top substrate defining the cavities of the device. Alternatively, the insulating layer may also be an oxide layer. The bonding material may also be a polymer or a silicon or glass frit,

Third substrate:
Optionally, the mobile mass and the frame are integrated in a third substrate, which is interposed between the first and the second substrate. The device may then consist of three substrates: The first and/or the second substrates are provided with cavities in the area where the third substrate has its mobile mass. So the mobile mass can move according to the acceleration applied or according to electromagnetic fields deflecting the movable structure.

### Separation space

Optionally, the frame and the MEMS structure are separated by a separation space (a trench in the MEMS layer, or a slot). This trench may define (in a top plan view of the frame) a rectangle or a polygon line running around the MEMS structure and it provides for electrical isolation. The separation space may be as narrow as a few microns (in a direction parallel to the surface). In the z-direction (i.e. perpendicular to the surface of the substrate) the trench penetrates the MEMS layer completely.

Alternatively, the electrical isolation may be achieved by areas of non-conducting material between the frame and the MEMS structure.

Multiple axis acceleration detection:
Preferably, the device comprises two or more movable structures arranged side by side in close proximity. The frame surrounds the two or more movable structures and has a separating section (i.e. a separating beam) arranged between the movables structures. So the movable structures are electrically isolated form each other and from further external influences. Three movables structures may be arranged in one row, in a square area or rectangular area encompassing the movables structures. Other arrays are also possible, but they might be less efficient in using the available chip area.

Acceleration sensor.

Preferably the device is an acceleration sensor integrated in at least one of said at least two substrates. The patents US 5,220,835 (Ford), US 5,488,864 (Ford), US 5,900,550 (Ford), US 6,000,287 (Ford), US 6,082,197 (Zexel), US 6,308,568 (Murata), US 5,377,544 (Motorola) show linear acceleration sensors and the patents EP 0 623 807 A1 (GM), US 5,329,815 (Motorola) show rotation rate sensors. The whole variety of designs may be used for the movable structure. However, the invention is not limited to the designs shown in those patents.

Multi-axis sensor:
Optionally, the movable structures of a multi-axis device are sensitive to mutually different directions. Each movable structure is sensitive to only one acceleration direction. Combining three single-axis movable structures, each being sensitive to only one of the directions x, y and z, results in a most preferred embodiment.

It is also possible to use the frame in combination with rotation rate MEMS sensors. One or more of the movable structure may also be sensitive to a rotation (gyro) or to other type of physical variable that can be detected by capacitive measurements.

The device may also be an actuator, e.g. a switch. The movable structure may be a cantilever that is attracted to an electrode for making contact. When the attracting electrical field is removed, the cantilever moves back to its still position.

Movement detection electrodes:
Preferably, the first substrate comprises electrodes for detecting a movement of the mobile mass. The second substrate is then only a cap for protecting the MEMS structure. If the MEMS structure is an actuator there are control electrodes for changing the position of the cantilever element (still position vs. deflected position). The invention does not propose new electrode structures but refers to well known prior art electrode structures.

The method for manufacturing the device may involve one or more of the following steps.
- forming the conducting frame and the movable structure in a common MEMS layer.
- interposing a third substrate at the interface between the first and the second substrate, said third substrate comprising the movable structure and the frame;
- etching a trench (separation space) into the third substrate for separating the frame from the sensor;
- etching the peripheral face of the second substrate to generate an inclined section;
- depositing a metal layer bridging the inclined peripheral face and the frame;
- bonding the frame and the second substrate at their mating main surfaces by an insulating bonding material, preferably by a silicon direct bonding (SDB). Alternatively, a eutectic/thermo compression bonding may be used for bonding the substrates one to another.

Silicon direct bonding is a method well known in the art (see e.g. US 7,442,662). The following detailed description and the combination of all claims present further advantageous embodiments and element combinations of the invention.

Any optional element that has been explained in relation to the MEMS system may also be used in combination with an electronic circuit in place of the movable structure.

### Brief description of the drawings

The accompanying drawings further illustrate the invention and serve to explain the preferred embodiments in combination with the detailed specification:
- Fig. 1a, b: a schematic representation of a device with two movable structures arranged side by side;
- Fig. 2a - c: a schematic cross-section of a device with two movable structures in more detail;
- Fig. 3: a schematic top plan view of a frame arrangement on a wafer,
- Fig. 4: a further variant of a frame,
- Fig. 5: a device with a T-shaped z-axis sensor.
- Fig. 6: a schematic cross-section of a device with two micro-electronic circuits (section B-B of Fig. 7);
- Fig. 7: a schematic plan view of along line A-A of Fig. 6.

Generally speaking, like reference numerals refer to identical parts.

### Preferred Embodiments

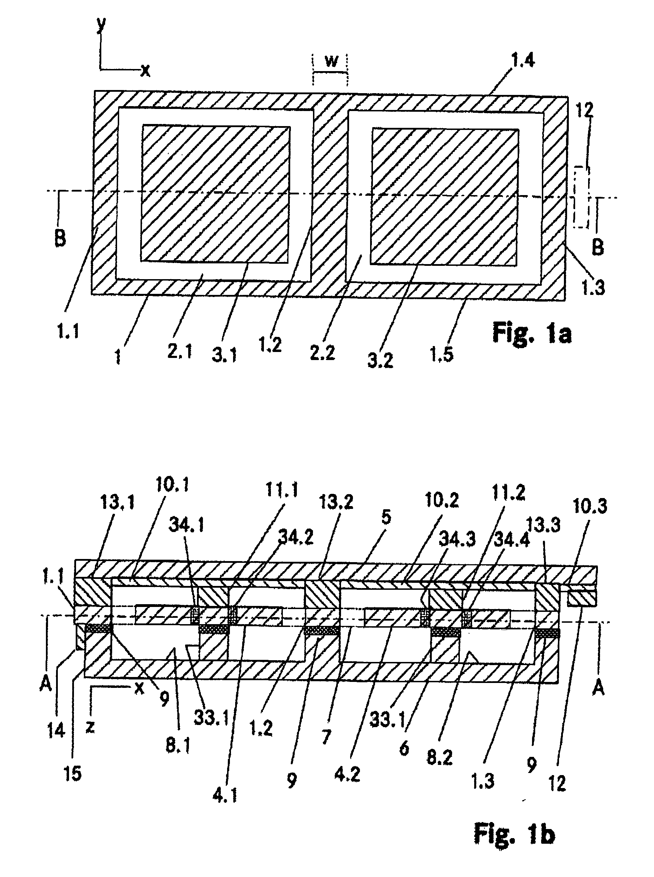

Fig. 1a, b illustrate a possible embodiment of the invention. Fig. 1a is a cross-section along the line A-A shown in Fig. 1b and Fig. 1b is a cross-section along the line B-B in Fig 1a. A frame 1 having a rectangular shape with for outer sections 1.1, 1.3, 1.4, 1.5 and an intermediate section 1.2 defines two separate free areas (windows). There is a sensor 3.1, 3.2 in each of said free areas. The sensors 3.1, 3.2 are implemented in MEMS technology. They each comprise a mobile mass for sensing the acceleration exerted on the device. The sensors 3.1, 3.2 are e.g. single axis sensors of a known structure (see background of the invention). They may detect e.g. x- and y-axis accelerations. The sensors 3.1, 3.2 are separated by a separation space 2.1, 2.2 from the frame 1. The beam section 1.2 of the frame separates the two sensors 3.1, 3.2 from each other.

The frame may have a width w (measured in x-direction) of the section 1.2.of e.g. 50 µm (micron). The sections 1.4 and 1.5 may have a different width (measured in y-direction). The same is true for the sections 1.1 and 1.3.

As shown in Fig. 1b the frame 1 is on the same level in z-direction as the mobile masses 4.1, 4.2 of the sensors 3.1, 3.2. In fact, they are made from the same substrate 7. Substrate 7 corresponds to the MEMS layer (active layer). The frame 1 is connected to the third substrate 7, which is sandwiched between a first substrate 5 and a second substrate 6. So the third substrate 7 is forming the interface between first substrate 5 and second substrate 6. All three substrates 5, 6, 7 are preferably made of crystalline silicon.

The frame 1 is attached to the second substrate 6 by an insulating bonding layer 9 (e.g. silicon dioxide). The bonding layer 9 substantially covers all sections 1.1 - 1.5 of the frame 1. In the top plan view the area of the bonding layer 9 corresponds to the top plan view of the area of the frame 1 shown in Fig. 1a. The second substrate 6 has two cavities 8.1, 8.1, one for each mobile mass 4.1, 4.2. The mobile masses 4.1, 4.2 are supported at the distance from the ground plane of the cavity 8.1, 8.2 e.g. by a central post 33.1, 33.2. The mobile mass 4.1, 4.2, which may surround the central post 33.1, 33.2, is connected via a flexible suspensions 34.1, ..., 34.4 to the central post. The flexible suspensions may have a known shape and structure and is not shown in detail in Fig. 1b. The first substrate 5 is covered with an insulating layer 10.1, 10.2 in the area below the mobile mass 4.1, 4.2.

The MEMS structures of substrate 7 are connected to driving and sensing electrodes 12 arranged at the outside of the device on insulating layer 10.3 of substrate 5 via metallic sealing 11.1, 11.2. The details of the electrode configuration and the conductor path between the metallic sealing 11.1, 11.2 and the driving and sensing electrodes 12 are not shown, but can be implemented as known in the prior art. The invention is not directed to those details.

The frame 1 (in Fig. 1b: sections 1.1 - 1.3) are electrically connected to the substrate 5 by metallic sealing 13.1 - 13.3. It is to be noticed that there is no insulating layer 10.1 - 10.3 in the area of the metallic sealing 13.1 - 13.3. So there is a direct electrical connection between the frame 1 and the bulk material of the substrate 5. The metallic sealing 13.1 - 13.3 has a geometric shape in the top plan view that is similar to the shape of the frame 1 (see Fig. 1a).

In order to establish an electrical connection between the frame 1 and the substrate 6 there is a metallic pad 14 at the peripheral face 15 bridging the non-conducting bonding layer 9 between the main face of the substrate 6 and the frame 1. In Fig. 1b the metallic pad 14 is placed just on one end of the device (opposite to the side with the electrodes 12). However, the metallic pad 14 may also extend to the sections 1.4 and 1.5 (and even to section 1.3) of the frame (see Fig. 1a).

The cavities 8.1, 8.2 shown in Fig. 1b are completely closed between the substrates so that the MEMS structure is encapsulated. According to the invention, the sensors 3.1, 3.2 are shielded from external stray fields and electromagnetic interference by a Faraday cage. This cage is implemented by the substrates 5 and 6 and by the frame 1, which all have a sufficient bulk conductivity (e.g. at least 1 mOhm x cm, preferably 10 - 20 mOhm x cm), and which are electrically connected with one another by metallic sealing 13.1 - 13.3 and by he metallic pad 14.

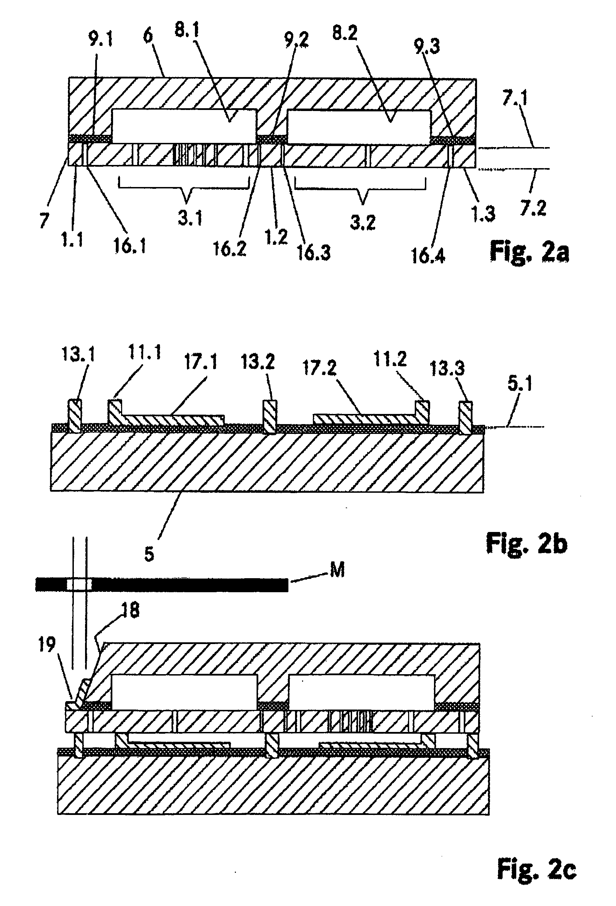

Fig. 2a - c illustrate a preferred method of manufacturing the device of the invention. Fig. 2a shows a SOI-structure (silicon on insulator) representing the second and third substrate 6, 7 shown in the schematic diagram of Fig. 1 b. The main surface 7.1 of the substrate 7 is bonded to the opposing main surface of the substrate 6, which is covered by the oxide layer 9.1, 9.2, 9.3. The structure etched into the SOI-structure corresponds to first and second sensor 3.1, 3.2 and to the frame 1 (sections 1.1, 1.2 etc.). The fact, that the sensors 3.1 and 3.2 are oriented in different directions is schematically indicated in Fig. 2a by differently arranged penetrations (trenches) in the sensor area of substrate 7. The details of the support of the movable mass and of the flexible suspension are not shown as they are not relevant for the present invention.

The frame sections 1.1 - 1.3 are separated from the MEMS structure of the sensors 3.1, 3.2 by narrow slots or trenches 16.1 - 16.4. The trenches 16.1 und 16.2 correspond to the separation space 2.1 of Fig. 1a and the trenches 16.3 und 16.4 correspond to sections of the separation space 2.2 of Fig. 1a. It is evident from Fig. 2a that the trenches 16.1, ..., 16.4 are placed outside the cavities 8.1, 8.2 and that the MEMS structure is therefore supported on the rim encompassing the cavities 8.1, 8.2.

Fig. 2b shows the substrate 5 carrying the electrodes 17.1, 17.2 for detecting the movement of the mobile mass of the MEMS structure. The metallic sealings 11.1, 11.2 are placed at the position where the MEMS structure needs to be contacted. In Fig. 2b the position is somewhat close to the trench 16.1 and 16.4, respectively. The metallic sealing 13.1, 13.2, 13.3 is placed directly on the substrate 5 at an area directly opposite to the frame sections 1.1, 1.2, 1.3.

Fig. 2c shows the device after bonding the two substrates 5 and 7 at their mating main surfaces 5.1 and 7.2 along the metallic sealings 13.1, 13.2, 13.2, 11.1, 11.2. The peripheral face 18 has been etched in the area of the frame 1 to get an Inclined face. A metal layer may then be deposited through a mask M to provide the electrical contact between the frame and the top substrate 6.

The preferred embodiments illustrate the following three measures:
1. At the level of the MEMS structures design, a surrounding frame is designed around each MEMS structure that is etched in the active layer. The MEMS structures are (partially) above a cavity, which enables the mechanical movement. The decoupling frame is clamped or fixed to the substrate. It is usually insulated by a dioxide layer.
2. At the cap and interconnection level, an electrical connection of this frame is implemented, Independent of the connections to the different parts of the MEMS structures. The connection is realized during the wafer bonding process through the metallic sealing. The electrical path connects the decoupling frame 1 to ground voltage, which is also the voltage of the substrate of the capping wafer.
3. And, finally, the substrate of the active wafer (MEMS) is connected to the ground voltage. This requires some additional technological steps because the substrate is normally insulated from the active MEMS layer by the embedded oxide layer of the SOI structure. As an example, the substrate, and the embedded oxide layer of the active wafer, can be chemically etched, locally, on the edge of the chip, above the decoupling frame, and then, a thick metallic layer can be deposited, through a mechanical shadow mask, in order to cover at the same time, the part of the active layer (at the frame level) which has been uncovered by the etching of the embedded oxide layer, and the edge of the etched part of the substrate.

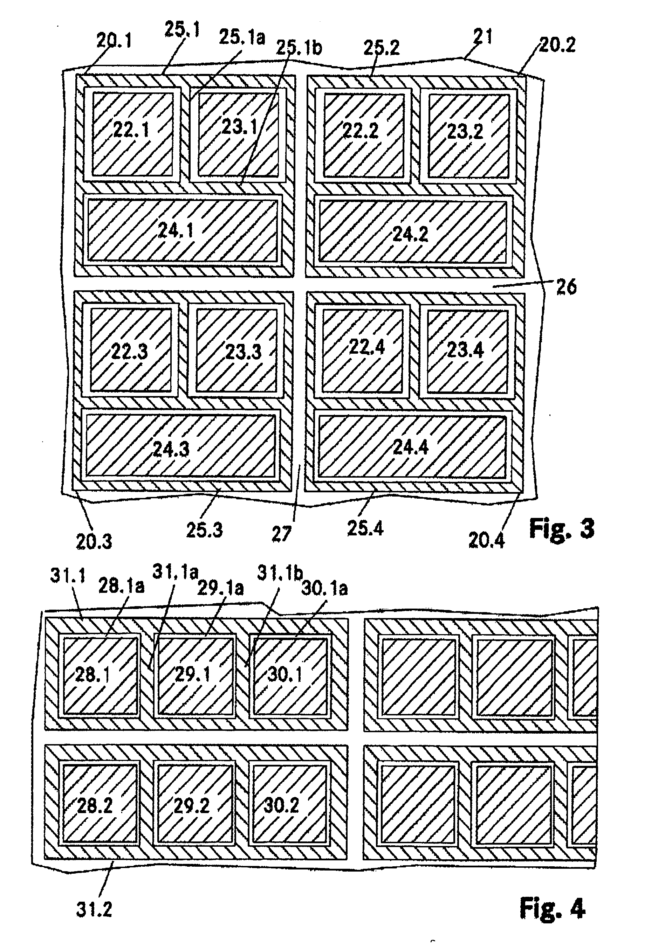

Fig. 3 and 4 show further embodiments having a different geometric array of sensors. Fig. 3 represents a top plan view of a part of a wafer 21 with a regular array of devices 20.1, ..., 20.4 detecting acceleration in 3 axes. Each of the devices 20.1, ..., 20.4 consists of three single-axis sensors namely an x-axis sensor 22.1, ..., 22.4, a y-axis sensor 23.1, ..., 23.4 and a z-axis sensor 24.1, ..., 24.4. In the example of Fig. 3 the x- and y-axis sensors 22.1, ..., 22.4 and 23.1, ..., 23.4 use the same amount of chip area, while the z-axis sensor 24.1, ..., 24.4 needs more area. The x-and y-axis sensors 22.1, 23.1 have a square shape and are arranged in a row along the side of the z-axis sensor 22.3, which has a rectangular area of about the same length as the two other sensors 22.1, 23.1. Each device 20.1, ..., 20.4 also comprises a frame 25.1, ..., 25.4 according to the invention. The frame 25.1 separates the sensors 22.1, 23.1, 24.1 by beam like sections 25.1a, 25.1b. The devices 20.1, ..., 20.4 are separated by trenches 26, 27 for cutting the wafer into chips. The contact electrodes for contacting the drive and sensing electrodes are not shown in Fig. 3.

Fig. 4 shows an array where each device comprises 3 single-axis sensors 28.1, 29.1, 30.1 and 28.2, 29.2, 30.2 arranged in a line. In this example the areas of the individual sensors 28.1, 29.1, 30.1 are shown to use the same amount of chip area. The frame 31.1, 31.2 has quasi three rectangular windows in a row and each window is occupied by a sensor 28.1, 29.1, 30.1 and 28.2, 29.2, 30.2 respectively, leaving a slot (having the shape of a rectangle in the top plan view of Fig. 4) between each sensor and the surrounding frame 31.1. The frame 23.1 separates the sensors 28.1, 29.1, 30.1 by beam like sections 31.1a, 311 b, the separating sections of the frame having a T-shape (in the top plan view).

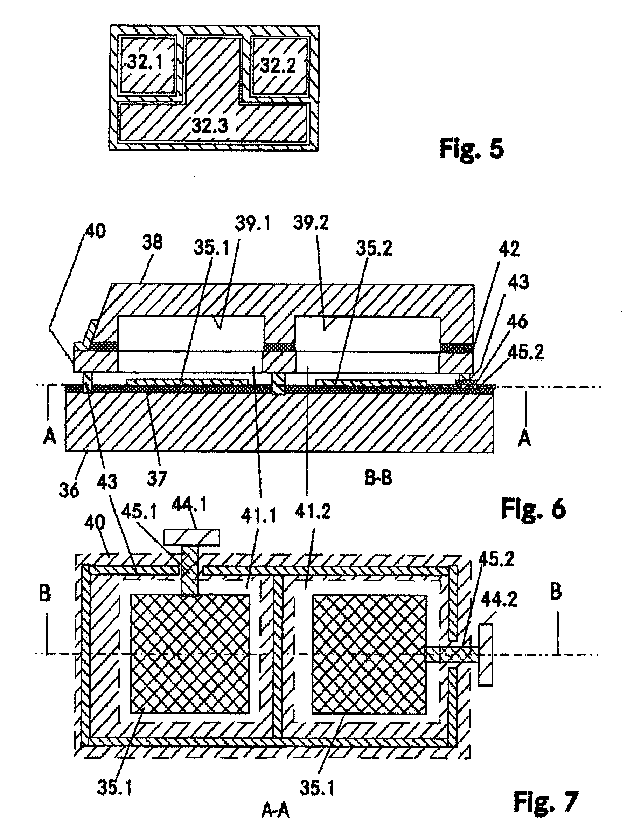

Fig. 5 shows a preferred embodiment of an acceleration detection device. The x- and y-axis sensors 32.1 and 32.2 have a square-type shape while the z-axis sensor 32.3 has a T-shape in the top plan view (i.e. in the z-directional view). The x- and y-axis sensors 32.1, 32.2 are arranged at each side of the T-shape of the z-axis sensor 32.3, so that the overall area occupied by the three sensors 32.1, 32.2, 32.3 has a rectangular shape. The z-axis sensor may have a mobile mass that is supported by a central post (not shown) as disclosed by the prior art mentioned in the introduction of this specification (US 4,736,629; US 5,404,749 etc.).

Fig. 6 and 7 shows a further embodiment of the invention. Instead of a MEMS system with a movable structure there are two electronic circuits 35.1, 35.2 on a substrate 36. The electronic circuits are electrically isolated from the bulk of the substrate 36 e.g. by a insulation layer 37. The electronic circuits 35.1, 35.2 may be ASICs (e.g. a processor, a data communication circuit a sensor control circuit and) are not shown in detail.

A cap wafer substrate 38 is fixed on top of the substrate 36 and forms for each electronic circuit 35.1, 35.2 a cavity 39.1, 39.2. A silicon frame 40 is bonded to the cap wafer substrate 38 and has two openings 41.1, 41.2 aligned with the cavities 39.1, 39.2 and having the same size as the cavities 39.1, 39.2. The openings 41.1, 41.2 are larger than the area of the electronic circuits 35.1, 35.2 so that there is no mechanical or electrical contact between the frame 40 and the electronic circuits 35.1, 35.2. The bonding layer 42 between the frame 40 and the cap wafer substrate 38 may be an insulator. In fact, the frame 40 may be implemented on the substrate 38 in the manner of a SOI (silicon on insulator) structure.

The frame 40 and the substrate 36 are electrically connected by a metallic sealing 43. The metallic sealing 43 forms a closed line around each electronic circuit 35.1, 35.2. Only at local spots, where there is an electric connection 45.1, 45.2 from the electronic circuit 35.1, 35.2 to an electrode pad 44.1, 44.2 arranged outside of the frame 40, is there a small opening in the Faraday cage structure. To electrically separate the electric connection 45.1 from the frame 40 and the sealing there is e.g. a thin insulating layer 46 between the electric connection 45.1 and the metallic sealing 43.

The electric connection between the structure (e.g. mobile mass, electronic circuit) inside the cavity and the contact pad at the outside and in particular the manner in which the Faraday cage is made around this local electrical opening may be the same for MEMS structure and for electronic circuits. Accordingly, the details shown in Fig. 6, 7 may be also used for the embodiments shown in Fig. 1 - 5.

The invention is not limited to the embodiments shown in the drawings. The geometric arrangement of the sensors depends on the characteristics of the sensors (required chip area, particular two-dimensional shape, place of contact electrodes etc.) and on the desired efficient use of die area. Instead of using SOI-technology for providing the MEMS structure with cavities below the mobile masses it is also possible to use other techniques that require only one substrate instead of two. The invention can be applied to many different movable structures e.g. as shown in the prior art cited in the "Background, prior art" section of this specification. The movable mass may also be an actuator e.g. an RF switch (see (see e.g. US 7,501,911).

While it is preferable that each movable structure is in a separate cavity which is protected by a Faraday cage structure according to the invention, it is also possible to have two movable structures within the same cavity. More generally speaking, the invention can be applied whenever a cavity on a microelectronic level has to be shielded against external electromagnetic fields.

The external metal layer for electrically connecting the frame may be arranged on one or several spots along the connection between the second and third substrate. It may also be a continuous line around the frame.

In summary, the invention provides a technical solution to minimize electrical interference between adjacent sensors or actuators.

## Claims

1. A micro-electronic device, preferably a micro-electromechanical system (MEMS) device comprising
at least two substrates (5, 6),
a micro-electronic structure, preferably at least one movable structure in a MEMS-layer,
wherein said micro-electronic structure, preferably said movable structure (4.1, 4.2) is arranged in a cavity (8.1, 8.2) which is encapsulated between the at least two substrates (5, 6, 7),
an electrically conducting frame (1) surrounding said micro-electronic structure, preferably said movable structure (3.1, 3.2), and arranged at an interface of the two substrates (5, 6),
wherein the frame (1) is electrically separated from said micro-electronic structure, preferably form said movable structure (3.1, 3.2)
wherein the frame is electrically connected by at least a first and a second electrically conducting connection (13.1, 13,2, 13.3; 14) to said first (5) and second substrate (6), respectively,
**characterised in that** each of the at least two substrates (5, 6) being a single body, preferably mainly consisting of a semiconductor material,
and **in that** the first and second substrates and the frame all have a sufficient bulk conductivity to form a Faraday cage.

2. The device according to claim 1, wherein the frame (1) is part of the MEMS-layer.

3. The device according to one of claims 1 - 2, wherein the frame (1) consists of silicon and has a width (w) in a direction parallel to a main surface of the substrate (6) of not more than 150 µm (micron), preferably not more than 50 µm (micron).

4. The device according to claim 3, wherein the frame (1) consists of crystalline silicon that is sufficiently high doped for achieving an adequate conductivity to form a Faraday cage.

5. The device according to one of claims 1 - 4, wherein the first electrically conducting connection (13.1, 13.2, 13.3) is at an interface plane between the frame (1) and the first substrate (5).

6. The device according to one of claims 1 - 5, wherein the second electrically conducting connection is a layer (14) applied at an outer periphery of the frame (1) and a peripheral face (15) of the second substrate (6).

7. The device according to claim 6, wherein the peripheral surface (18) of the second substrate (6) has a section that is inclined at an angle of less than 90° with respect to the main surface and wherein the conducting layer (19) is applied to the inclined section of the peripheral surface (18).

8. The device according to claim 7, wherein the frame (1) and the second substrate (6) are connected at their mating main surfaces by an insulating bonding material (9).

9. The device according to claim 8, wherein the frame (1) and the movable structure are separated by a separation space (2.1, 2.2).

10. The device according to claim 1 - 9, comprising two or more movable structures (22.1, 23.1, 24.1) arranged side by side, wherein the frame (25,1) surrounds the two or more movable structures (22.1, 23.1, 24.1) and has a separating section (25.1a, 25.1b) arranged between the movable structure (22.1, 23.1, 24.1).

11. The device according to one of claims 1 - 10, wherein the movable structure is an inertial mass responsive to acceleration.

12. The device according to claim 11, wherein the two movable structures are detection elements of sensors (3.1, 3.2) that are sensitive to mutually different directions, preferably to at least two of the directions x, y and z.

13. The device according to claim 1-12, wherein the first substrate (5) comprises electrodes (17.1, 17.2) for detecting or activating a movement of the movable structure (4.1, 4.2).

14. Method for manufacturing the device of claim 1 comprising the steps of:
providing at least two substrates (5, 6, 7) forming a cavity (8.1, 8.2), wherein each of the substrates is a single body, preferably mainly consisting of a semiconductor material,
providing at least one micro-electronic structure, preferably a movable structure in a MEMS-layer, said micro-electronic structure being provided in the cavity (8.1, 8.2),
providing an electrically conducting frame (1) at an interface of the two substrates and the frame surrounding the micro-electronic structure, preferably the movable structure (3.1, 3.2),
wherein said substrates (5, 6, 7) and the frame (1) all have a sufficient bulk conductivity to form a Faraday cage.
bonding the two substrates and the conducting frame together for encapsulating the micro-electronic structure (4.1, 4.2) in the cavity (8.1, 8.2), wherein the frame (1) surrounds the micro-electronic structure (3.1, 3.2) and the frame (1) is electrically separated from said micro-electronic structure (3.1, 3.2) inside said frame (1),
providing a first and a second electrically conducting connection between said frame and said first and second substrates, respectively.

15. Method according to claim 14, comprising the step of forming the conducting frame and the movable structure in a common MEMS layer.

16. Method according to claim 14, comprising the step of interposing a third substrate (7) between the first and the second substrate (5, 6), said third substrate (7) comprising the movable structure (4.1, 4.2) and the frame (1).

17. Method according to claim 15, comprising the step of etching a trench (16.1, ..., 16.4) into the third substrate (7) for separating the frame (1) from the movable structure (3.1, 3.2).

18. Method according to one of claims 14 - 16, comprising the step of etching an inclined section of the peripheral face (18) of the second substrate (6).

19. Method according to claim 17, comprising the step depositing a metal layer (19) connecting the inclined peripheral face and the frame (1).

20. Method according to claim 19, comprising the step of bonding the frame (1) and the second substrate (6) at their mating main surfaces by an insulating bonding (9) material.

## Patentansprüche

1. Mikroelektronische Vorrichtung, vorzugsweise eine mikroelektromechanische Systemvorrichtung (MEMS-Vorrichtung), aufweisend
mindestens zwei Substrate (5, 6),
eine mikroelektronische Struktur, vorzugsweise mindestens eine bewegliche Struktur in einer MEMS-Schicht,
wobei die mikroelektronische Struktur, vorzugsweise die bewegliche Struktur (4.1, 4.2) in einem Hohlraum (8.1, 8.2) angeordnet ist, der zwischen den mindestens zwei Substraten (5, 6, 7) eingekapselt ist,
einen elektrisch leitenden Rahmen (1), der die mikroelektranische Struktur, vorzugsweise die bewegliche Struktur (3.1, 3.2) umgibt und an einer Grenzfläche der zwei Substrate (5, 6) angeordnet ist,
wobei der Rahmen (1) elektrisch von der mikroelektronischen Struktur, vorzugsweise der beweglichen Struktur (3.1, 3.2) getrennt ist,
wobei der Rahmen elektrisch durch mindestens eine erste und eine zweite elektrisch leitende Verbindung (13.1, 13.2, 13.3; 14) an das erste (5) bzw. zweite (6) Substrat angeschlossen ist,
**dadurch gekennzeichnet, dass**
jedes der mindestens zwei Substrate (5, 6) ein einzelner Körper ist, vorzugsweise vorwiegend bestehend aus einem Halbleitermaterial,
und dass das erste und zweite Substrat und der Rahmen alle eine ausreichende Volumenleitfähigkeit haben, um einen Faradayschen Käfig zu bilden.

2. Vorrichtung nach Anspruch 1, wobei der Rahmen (1) Teil der MEMS-Schicht ist.

3. Vorrichtung nach einem der Ansprüche 1 bis 2, wobei der Rahmen (1) aus Silizium besteht und eine Breite (w) in eine Richtung parallel zu einer Hauptfläche des Substrats (6) von nicht mehr als 150 µm (Mikron), vorzugsweise nicht mehr als 50 µm (Mikron) hat.

4. Vorrichtung nach Anspruch 3, wobei der Rahmen (1) aus kristallinem Silizium besteht, das ausreichend hoch dotiert ist, um eine angemessene Leitfähigkeit zur Bildung eines Faradayschen Käfigs zu erreichen.

5. Vorrichtung nach einem der Ansprüche 1 bis 4, wobei die erste elektrisch leitende Verbindung (13.1, 13.2, 13.3) eine Grenzflächenebene zwischen dem Rahmen (1) und dem ersten Substrat (5) ist.

6. Vorrichtung nach einem der Ansprüche 1 bis 5, wobei die zweite elektrisch leitende Verbindung eine Schicht (14) ist, die an einer äußeren Peripherie des Rahmens (1) und einer peripheren Fläche (15) des zweiten Substrats (6) angebracht ist.

7. Vorrichtung nach Anspruch 6, wobei die periphere Fläche (18) des zweiten Substrats (6) einen Abschnitt hat, der in einem Winkel von weniger als 90° in Bezug auf die Hauptfläche geneigt ist, und wobei die leitende Schicht (19) am geneigten Abschnitt der peripheren Fläche (18) angebracht ist.

8. Vorrichtung nach Anspruch 7, wobei der Rahmen (1) und das zweite Substrat (6) an ihren passenden Hauptflächen durch ein isolierendes Verbindungsmaterial (9) verbunden sind.

9. Vorrichtung nach Anspruch 8, wobei der Rahmen (1) und die bewegliche Struktur durch einen Trennraum (2.1, 2.2) getrennt sind.

10. Vorrichtung nach Anspruch 1 bis 9, aufweisend zwei oder mehr bewegliche Strukturen (22.1, 23.1, 24.1), die Seite an Seite angeordnet sind, wobei der Rahmen (25.1) die zwei oder mehr beweglichen Strukturen (22.1, 23.1, 24.1) umgibt und einen Trennabschnitt (25.1a, 25.1b) aufweist, der zwischen den beweglichen Strukturen (22.1, 23.1, 24.1) angeordnet ist.

11. Vorrichtung nach einem der Ansprüche 1 bis 10, wobei die bewegliche Struktur eine träge Masse ist, die auf eine Beschleunigung anspricht.

12. Vorrichtung nach Anspruch 11, wobei die zwei beweglichen Strukturen Detektionselemente von Sensoren (3.1, 3.2) sind, die auf wechselseitig unterschiedliche Richtungen, vorzugsweise auf mindestens zwei der Richtungen x, y und z ansprechen.

13. Vorrichtung nach Anspruch 1 bis 12, wobei das erste Substrat (5) Elektroden (17.1, 17.2) zum Erfassen oder Aktivieren einer Bewegung der beweglichen Struktur (4.1, 4.2) aufweist.

14. Verfahren zum Herstellen der Vorrichtung nach Anspruch 1, umfassend die Schritte des:
Bereitstellens von mindestens zwei Substraten (5, 6, 7), die einen Hohlraum (8.1, 8.2) bilden, wobei jedes der Substrate ein einzelner Körper ist, der vorzugsweise vorwiegend aus einem Halbleitermaterial besteht,
Bereitstellens mindestens einer mikroelektronischen Struktur, vorzugsweise einer beweglichen Struktur in einer MEMS-Schicht, wobei die mikroelektronische Struktur in dem Hohlraum (8.1, 8.2) bereitgestellt ist,
Bereitstellens eines elektrisch leitenden Rahmens (1) an einer Grenzfläche der zwei Substrate, und wobei der Rahmen die mikroelektronische Struktur, vorzugsweise die bewegliche Struktur (3.1, 3.2) umgibt,
wobei die Substrate (5, 6, 7) und der Rahmen alle eine ausreichende Volumenleitfähigkeit haben, um einen Faradayschen Käfig zu bilden,
Verbindens der zwei Substrate und des leitenden Rahmens zum Einkapseln der mikroelektronischen Struktur (4.1, 4.2) in dem Hohlraum (8.1, 8.2), wobei der Rahmen (1) die mikroelektronische Struktur (3.1, 3.2) umgibt und der Rahmen (1) elektrisch von der mikroelektronischen Struktur (3.1, 3.2) im Inneren des Rahmens (1) getrennt ist,
Bereitstellens einer ersten und einer zweiten elektrisch leitenden Verbindung zwischen dem Rahmen und dem ersten bzw. zweiten Substrat.

15. Verfahren nach Anspruch 14, aufweisend den Schritt des Bildens des leitenden Rahmens und der beweglichen Struktur in einer gemeinsamen MEMS-Schicht.

16. Verfahren nach Anspruch 14, aufweisend den Schritt des Einfügens eines dritten Substrats (7) zwischen dem ersten und dem zweiten Substrat (5, 6), wobei das dritte Substrat (7) die bewegliche Struktur (4.1, 4.2) und den Rahmen (1) aufweist.

17. Verfahren nach Anspruch 15, aufweisend den Schritt des Ätzens eines Grabens (16.1, ..., 16.4) in das dritte Substrat (7) zum Trennen des Rahmens (1) von der bewegliche Struktur (3.1, 3.2).

18. Verfahren nach einem der Ansprüche 14 bis 16, aufweisend den Schritt des Ätzens eines geneigten Abschnitts der peripheren Fläche (18) des zweiten Substrats (6).

19. Verfahren nach Anspruch 17, aufweisend den Schritt des Abscheidens einer Metallschicht (19), die die geneigte periphere Fläche und den Rahmen (1) verbindet.

20. Verfahren nach Anspruch 19, aufweisend den Schritt des Verbindens des Rahmens (1) und des zweiten Substrats (6) an ihren passenden Hauptflächen durch ein isolierendes Bindematerial (9).

## Revendications

1. Dispositif micro-électronique, de préférence dispositif à système micro-électromécanique (MEMS) comportant
au moins deux substrats (5, 6),
une structure micro-électronique, de préférence au moins une structure mobile dans une couche MEMS,
ladite structure micro-électronique, de préférence ladite structure mobile (4.1, 4.2), étant disposée dans une cavité (8.1, 8.2) qui est encapsulée entre lesdits au moins deux substrats (5, 6, 7),
un cadre électriquement conducteur (1) entourant ladite structure micro-électronique, de préférence ladite structure mobile (3.1, 3.2), et étant disposé à une interface des deux substrats (5, 6),
le cadre (1) étant électriquement séparé de ladite structure micro-électronique, de préférence de ladite structure mobile (3.1, 3.2)
le cadre étant relié électriquement par au moins une première et une deuxième liaison électriquement conductrices (13.1, 13.2, 13.3; 14) auxdits premier (5) et deuxième (6) substrats, respectivement,
**caractérisé en ce que** chacun desdits au moins deux substrats (5,6) est un corps unique, de préférence principalement constitué d'un matériau semiconducteur, et **en ce que** les premier et deuxième substrats et le cadre présentent tous une conductivité volumique suffisante pour former une cage de Faraday.

2. Dispositif selon la revendication 1, le cadre (1) faisant partie de la couche MEMS.

3. Dispositif selon l'une des revendications 1 à 2, le cadre (1) étant constitué de silicium et présentant une largeur (w) dans une direction parallèle à une surface principale du substrat (6) ne dépassant pas 150 µm (micron), de préférence ne dépassant pas 50 µm (micron).

4. Dispositif selon la revendication 3, le cadre (1) étant constitué de silicium cristallin qui est suffisamment fortement dopé pour obtenir une conductivité adéquate afin de former une cage de Faraday.

5. Dispositif selon l'une des revendications 1 à 4, la première liaison électriquement conductrice (13.1, 13.2, 13.3) se trouvant à un plan d'interface entre le cadre (1) et le premier substrat (5).

6. Dispositif selon l'une des revendications 1 à 5, la deuxième liaison électriquement conductrice étant une couche (14) appliquée à une périphérie extérieure du cadre (1) et à une face périphérique (15) du deuxième substrat (6).

7. Dispositif selon la revendication 6, la surface périphérique (18) du deuxième substrat (6) présentant une section qui est incliné à un angle de moins de 90° par rapport à la surface principale et la couche conductrice (19) étant appliquée à la section inclinée de la surface périphérique (18).

8. Dispositif selon la revendication 7, le cadre (1) et le deuxième substrat (6) étant reliés au niveau de leurs surfaces principales d'accouplement par un matériau (9) de collage isolant.

9. Dispositif selon la revendication 8, le cadre (1) et la structure mobile étant séparés par un espace (2.1, 2.2) de séparation.

10. Dispositif selon l'une des revendications 1 à 9, comportant au moins deux structures mobiles (22.1, 23.1, 24.1) disposées côte à côte, le cadre (25.1) entourant lesdites au moins deux structures mobiles 22, 23.1 24.1) et comportant une section (25.1a, 25.1b) de séparation disposée entre les structures mobiles (22.1, 23.1, 24.1).

11. Dispositif selon l'une des revendications 1 à 10, la structure mobile étant une masse inertielle réagissant à l'accélération.

12. Dispositif selon la revendication 11, les deux structures mobiles étant des éléments de détection de capteurs (3.1, 3.2) qui sont sensibles à des directions mutuellement différentes, de préférence à au moins deux des directions x, y et z.

13. Dispositif selon l'une des revendications 1 à 12, le premier substrat (5) comportant des électrodes (17.1, 17.2) servant à détecter ou à activer un mouvement de la structure mobile (4.1, 4.2).

14. Procédé de fabrication du dispositif de la revendication 1, comportant les étapes consistant à :
mettre en place au moins deux substrats (5, 6, 7) formant une cavité (8.1, 8.2), chacun des substrats étant un corps unique, de préférence principalement constitué d'un matériau semiconducteur,
mettre en place au moins une structure micro-électronique, de préférence une structure mobile dans une couche MEMS, ladite structure micro-électronique étant placée dans la cavité (8.1, 8.2),
mettre en place un cadre électriquement conducteur (1) à une interface des deux substrats et du cadre entourant la structure micro-électronique, de préférence la structure mobile (3.1, 3.2),
lesdits substrats (5, 6, 7] et le cadre (1) présentant tous une conductivité volumique suffisante pour former une cage de Faraday,
coller ensemble les deux substrats et le cadre conducteur pour encapsuler la structure micro-électronique (4.1, 4.2) dans la cavité (8.1, 8.2), le cadre (1) entourant la structure micro-électronique (3.1, 3.2) et le cadre (1) étant électriquement séparé de ladite structure micro-électronique (3.1, 3.2) à l'intérieur dudit cadre (1),
mettre en place une première et une deuxième liaison électriquement conductrice entre ledit cadre et lesdits premier et deuxième substrats, respectivement.

15. Procédé selon la revendication 14, comportant l'étape consistant à former le cadre conducteur et la structure mobile dans une couche MEMS commune.

16. Procédé selon la revendication 14, comportant l'étape consistant à interposer un troisième substrat (7) entre le premier et le deuxième substrat (5, 6), ledit troisième substrat (7) comportant la structure mobile (4.1, 4.2) et le cadre (1).

17. Procédé selon la revendication 15, comportant l'étape consistant à graver une tranchée (16.1, ..., 16.4) dans le troisième substrat (7) pour séparer le cadre (1) de la structure mobile (3.1, 3.2).

18. Procédé selon l'une des revendications 14 à 16, comportant l'étape consistant à graver une section inclinée de la face périphérique (18) du deuxième substrat (6).

19. Procédé selon la revendication 17, comportant l'étape consistant à déposer une couche métallique (19) reliant la face périphérique inclinée et le cadre (1).

20. Procédé selon la revendication 19, comportant l'étape consistant à coller le cadre (1) et le deuxième substrat (6) au niveau de leurs surfaces principales d'accouplement par un matériau (9) de collage isolant.
